# EUROPEAN PATENT APPLICATION

(11) **EP 2 645 432 A1**
(43) Date of publication of application: **02.10.2013**
(21) Application number: 10827693.2
(22) Date of filing: 09.12.2010
(51) Int. Cl.: H01L 33/22

(54) **LIGHT EMITTING DEVICE AND MANUFACTURING METHOD THEREOF**

(30) Priority: 30.09.2010 CN 201010503051
(71) Applicant: Enraytek Optoelectronics Co., Ltd., Shanghai 201203 (CN)
(72) Inventor: CHANG, Richard, Rugin, Shanghai 201203 (CN); XIAO, Deyuan, Shanghai 201203 (CN)
(74) Representative: Groot Koerkamp, Jasper Henri
(86) International application number: PCT/CN2010/079607
(87) International publication number: WO 2012/040979

(57) **Abstract**

The present invention provides a light emitting device and a method for manufacturing the light emitting device. The light emitting device includes a susceptor and a light emitting diode set on the susceptor. The light emitting diode includes an electrode layer connected to the susceptor and an LED die set on the electrode layer. The electrode layer is provided with a pyramid array structure surface and the pyramid array surface works as a reflective surface of the light emitting diode. The LED die is provided with an alveolate surface which works as the light exiting surface of the LED. According to the light emitting device provided in the present invention, the emanative light generated by the LED is emitted or reflected to a desired emitting direction. Further, the light emitting device has an alveolate light exiting surface and an LED having a pyramid array reflective surface, which increases the light emitting and reflective area of the LED, thereby improving the luminous efficiency. Bisedes, the light emitting device adopts a surface mount technology, which is easy to implement.

## Description

### Cross Reference to Related Applications

The present application claims the priority of Chinese Patent Application No. 201010503051.8, entitled "A light emitting device and a manufacturing method thereof", and filed September 30, 2010, the entire disclosure of which is incorporated herein by reference.

### Field of the Invention

The present invention relates to semiconductor technology, and particularly relates to a light emitting device and a method for manufacturing the device.

### Background of the Invention

A light emitting diode (LED) is a semiconductor device which is activated by current to generate light of various colors. The III-V compound semiconductors, such as gallium nitride (GaN), which have wide band gap, high luminous efficiency, high electron saturation drift velocity, and stable chemical properties, have great application potential in high-brightness blue light emitting diodes, blue laser and other optoelectronic devices areas, and have aroused wide attention.

However, semiconductor light emitting diodes have low luminous efficiency in the prior art. As for light emitting diodes without package, the luminous efficiency is only a few percent. A lot of energy inside the device can not be sent out, thereby not only causing energy waste, but also affecting lifetime of the device. Therefore, it is of key importance to improve the luminous efficiency of semiconductor light emitting diodes.

Because of the above application requirements, a plurality of methods for improving the luminous efficiency of semiconductor light emitting diodes have been applied in device structure, for example, surface roughness, Metal reflector structure, and so on. Chinese patent publication No.CN1858918A discloses a kind of light emitting diodes and the under surface of the light emitting diodes forms an omnidirectional reflector structure, whereby the luminous efficiency of the light emitting diodes is improved. However, the method disclosed in this prior art needs to form a film comprising a plurality of high refractive index layers and low refractive index layers stacked on the substrate, of which the manufacturing process is very complex.

### Summary of the Invention

An object of the present invention is to provide a light emitting device for improving the luminous efficiency.

The light emitting device provided in the present invention comprises: a susceptor and a light emitting diode set on the susceptor. The light emitting diode comprises an electrode layer connected to the susceptor and an LED die set on the electrode layer.

The electrode layer is provided with a pyramid array structure surface and the pyramid array surface works as a reflective surface of the light emitting diode.

The LED die is provided with an alveolate surface which works as the light exiting surface of the LED.

The LED die comprises: an N-type semiconductor layer set on the electrode layer, an active layer set on the N-type semiconductor layer, and a P-type semiconductor layer set on the active layer. The alveolate surface is set on the P-type semiconductor layer. The diameter of the apertures on the alveolate surface is 200nm, the depth of of the apertures on the alveolate surface is 150nm, and the density of the apertures on the alveolate surface ranges from 1×10⁴ /mm² to 1×10¹⁰ /mm². The alveolate surface of the P-type semiconductor layer comprises a transparent electrode. The transparent electrode is made up of Nickel or gold films and has a thickness of 50nm. The N-type semiconductor layer is made up of N-doped GaN, and the P-type semiconductor layer is made up of P-doped GaN. The active layer is of the MQW active layer structure and made up of InGaN. The electrode layer is made up of titanium, aluminum or gold.

The light emitting device further comprises a first pin and a second pin set on the susceptor. The first pin is connected to a positive electroce of a power supply and the second pin is connected to a negative electrode of the power supply. The second pin is connected to the transparent electrode through a gold lead.

Optionally, the light emitting device further comprises a reflective layer on the susceptor and surrounding the LED, thereby forming a groove holding the LED. The groove is filled with a package resin, and the package resin has a lens structure.

In order to manufacturing the light emitting device, the present invention provides a method for manufacturing the light emitting device, comprising:
providing a substrate, and forming a pyramid array structure on a surface of the substrate;
forming an LED die on the surface of the substrate with the pyramid array structure, and a surface of the LED die which is opposite to the substrate having an alveolate surface;
removing the substrate, and forming an electrode layer in the original position of the substrate; and
providing a susceptor, and mounting the LED die and the electrode layer on the susceptor.

Wherein the step of providing a substrate and forming a pyramid array structure on a surface of the substrate comprises: providing a substrate, depositing a dielectric lalyer on the substrate, and patterning the dielectric layer to form a lattice-like hard mask; etching the substrate to form a pyramid array structure by using the lattice-like hard mask as a mask; removing the lattice-like hard mask.

Said substrate is a P-doped silicon substrate of (100) plane. Said etching the substrate to form a pyramid array structure by using the lattice-like hard mask as a mask comprises performing a wet etching on the substrate using tetramethyl ammonium hydroxide (TMAH) solution and forming a pyramid array structure, wherein the pyramids are provided with side walls in (111) planes and bottom surface in (100) planes. Said (111) planes are the formation surface of the LED die.

Optionally, said wet etching on the substrate using tetramethyl ammonium hydroxide (TMAH) solution is performed for 20 minutes and the etching temperature is 60∼80°C. An angle fromed by a sidewall of the pyramids and a bottom wall of the pyramids is 54.74 °. The density of the pyramids on the silicon substrate ranges from 4×10⁴ to 1×10⁸/mm²_{.}

Said forming an LED die on the (111) planes of the substrate comprising:
forming an N-type semiconductor layer on the (111) planes of the substrate, forming an active layer on the N-type semiconductor layer, and forming a P-type semiconductor layer on the active layer;
forming an alveolate surface using a photolithography or dry etching process on the P-type semiconductor layer; and
forming a transparent electrode on the alveolate surface.

The diameter of the apertures on the alveolate surface is 200nm, the depth of of the apertures on the alveolate surface is 150nm, and the density of the apertures on the alveolate surface ranges from 1×10⁴ /mm² to 1×10¹⁰ /mm². The transparent electrode is made up of Nickel or gold films, and has a thickness of 50nm. The transparent electrode is formed by plasma enhanced chemical vapor deposition (PECVD), atomic layer deposition (ALD) or ion beam deposition process using an e-GUN evaporator.

Optionally, the substrate is removed by using potassium hydroxide solution. Said electrode layer is made of titanium, aluminum or gold. Said removing the substrate and forming the electrode layer on the original position of the substrate is using a PECVD or a sputting process.

Said mounting the LED die and the electrode layer on the susceptor comprises:
forming a first pin and a second pin on the susceptor, wherein the first pin is adapted for connecting a positive electrode of a power supply and the second pin is adapted for connecting a negative electrode of the power supply; fixing the electrode layer on the first pin, and connecting the transparent electrode to the second pin through a gold lead.

Optionally, before mounting the LED die and the electrode layer on the susceptor, an annular reflective layer is formed on the susceptor. Said annular reflective layer is set surrounding the LED die. A groove surrounded by the annular reflective layer is filled with a package resin, until the package resin covers the LED die and the electrode layer. The surface of the packaging resin forms a lens structure.

According to the light emitting device provided in the present invention, the emanative light generated by the LED is emitted or reflected to a desired emitting direction. Further, the light emitting device has an alveolate light exiting surface and an LED having a pyramid array reflective surface, which increases the light emitting and reflective area of the LED, thereby improving the luminous efficiency. Bisedes, the light emitting device adopts a surface mount technology, which is easy to implement.

### BRIEF DESCRIPTION OF THE DRAWINGS

FIG. 1 is a schematic cross section view of a light emitting device in the first embodimen;

FIG. 1a is a top view of a pyramid array sturctrue shown in a dotted ellipse according to the FIG. 1;

FIG. 2 is a flow chart of a method for manufacturing the light emitting device in the first embodiment;

FIG. 3 is a flow chart of the step s1 in the first embodiment according to the method shown in FIG. 2;

FIGS. 4 to 13 are schematic side views of a light emitting device manufactured with the method in FIG. 2.

### DESCRIPTION OF THE PREFERRED EMBODIMENTS

Hereunder, the present invention will be described in detail with reference to embodiments, in conjunction with the accompanying drawings.

Although the present invention has been disclosed hereinafter as above with reference to preferred embodiments in details, the present invention can be implemented in other embodiments which are different. Therefore, the present invention should not be limited to the embodiments disclosed here.

As taught in the background of the invention, in order to improve the luminous efficiency of semiconductor light emitting diodes, the method disclosed in the prior art needs to form a film comprising a plurality of high refractive index layers and low refractive index layers stacked on the substrate, and the production process of the film is very complex.

In order to solve this problem, the present invention provides a light emitting device. The light emitting device comprises: a susceptor and a light emitting diode set on the susceptor. The light emitting diode comprises a pyramid array structure surface which works as a reflective surface of the light emitting diode, and an alveolate surface which works as the light exiting surface of the LED. The pyramid array structure surface increases the reflective area of the LED, and the alveolate surface increases the light emitting area of the LED, whereby the probility of light produced by an active layer of the LED being reflected or emitted to a desired emitting direction is increased. Therefore, the external quantum efficiency of the LED is increased, and so it is with the luminous efficiency of the LED.

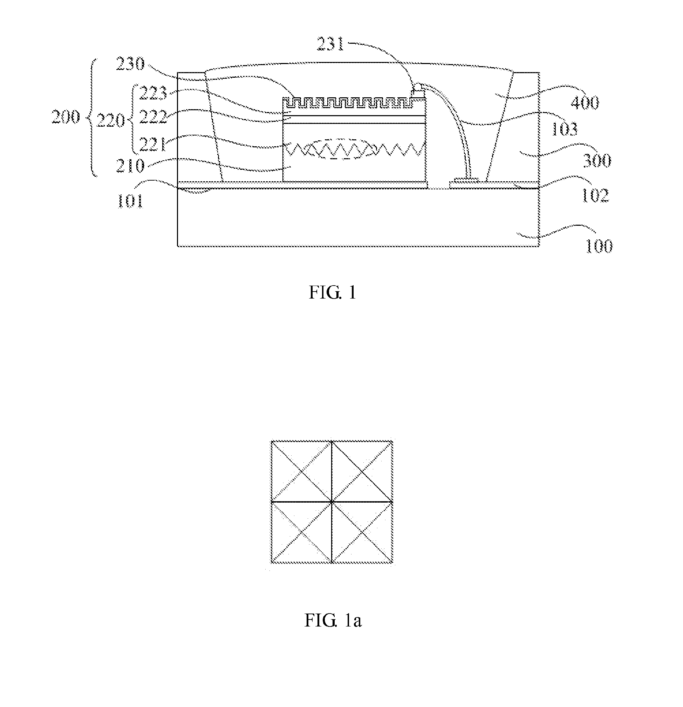

FIG. 1 is a schematic cross section view of a light emitting device in the first embodiment. Referring to FIG. 1, the light emitting device comprises: a susceptor 100, a first pin 101 connected to a positive electroce of a power supply, a second pin 102 connected to a negative electrode of a power supply, an electrode layer 210 fixed on the first pin 101, and an LED die 220 set on the electrode layer 210. The electrode layer 210 and the LED die 220 constitute an LED 200.

The susceptor 100 is adapted for bearing the weight of the LED 200, and is composed of conventional insulating substrate. The first pin 101 and the second pin 102, which are manufactured with conductive materials such as copper or aluminum, are set on a mounting surface of the susceptor 100, and penetrate through the susceptor 100 or extend along the surface of the susceptor 100 to a back surface of the susceptor 100, thus being connected to the positive electroce and the negative electrode of a power supply. In order to simplify the description, only parts of the first pin 101 and the second pin 102 which are on the mounting surface of the susceptor 100 are shown in the FIG. 1.

The electrode layer 210 comprises a pyramid array structure surface, referring to FIG. 1a (FIG. 1a is a top view of the pyramid array sturctrue shown in a dotted ellipse according to the FIG. 1). The pyramid array structure surface works as a reflective surface of the LED 200, and increases the reflective area of the LED 200, whereby the probility of light produced by an active layer of the LED 200 being reflected to a desired emitting direction is increased greatly. The electrode layer 210 is made up of titanium, aluminum, gold or other metals with higher reflectivity.

The LED die 220 comprises: an N-type semiconductor layer 221 set on the electrode layer 210, an active layer 222 set on the N-type semiconductor layer 221, and a P-type semiconductor layer 223 set on the active layer 222. In this embodiment, the N-type semiconductor layer 221 is made up of N-type doped GaN. The active layer 222 is of the MQW active layer structure, specifically, made up of InGaN, and adapted for generating a blue light at a wavelength of 470 nm. The P-type semiconductor layer 223 is made up of P-type doped GaN.

The P-type semiconductor layer 223 comprises an alveolate surface which works as the light exiting surface of the LED 200. The alveolate surface also increases the the reflective area of the LED 200, whereby the probility of light produced by an active layer of the LED 200 being reflected to a desired emitting direction is increased greatly, and so it is with the luminous efficiency of the LED 200.

The alveolate surface of the P-type semiconductor layer 223 comprises a transparent electrode 230, which is connected to the second pin 102. Specifically, the transparent electrode 230 is Nickel or gold films, and is connected to the second pin 102 through a connecting electrode 231 and a gold lead 103. In light of the foregoing, the N-type semiconductor layer 221 of the LED die 220 is connected to the first pin 101 through the electrode layer 210, and the P-type semiconductor layer 223 of the LED die 220 is connected to the second pin 102 through the transparent electrode 230, thereby supplying power to the active layer 222, and causing the active layer 222 to emit light.

In order to increase the reflective area, an annular reflective layer 300 is set on the susceptor 100 and surrounding the LED 200. A surface of the annular reflective layer 300 which is opposite to the LED 200 is coated with reflective material, such as barium oxide film. The surface of the annular reflective layer 300 is able to reflect the light escaping from the side of the LED 200 to the desired emitting direction, thereby further improving the luminous efficiency.

A groove is formed between the annular reflective layer 300 and the LED 200, and the groove is filled with a packaging resin 400 which covers the LED 200. On one hand, the packaging resin 400 protects the LED 200; on the other hand, the surface of the packaging resin 400 is shaped embowed and has a lens structure, thus assembling the light emitted from or reflected by the LED 200 to the desired emitting direction, and increasing the brightness of the light emitting device.

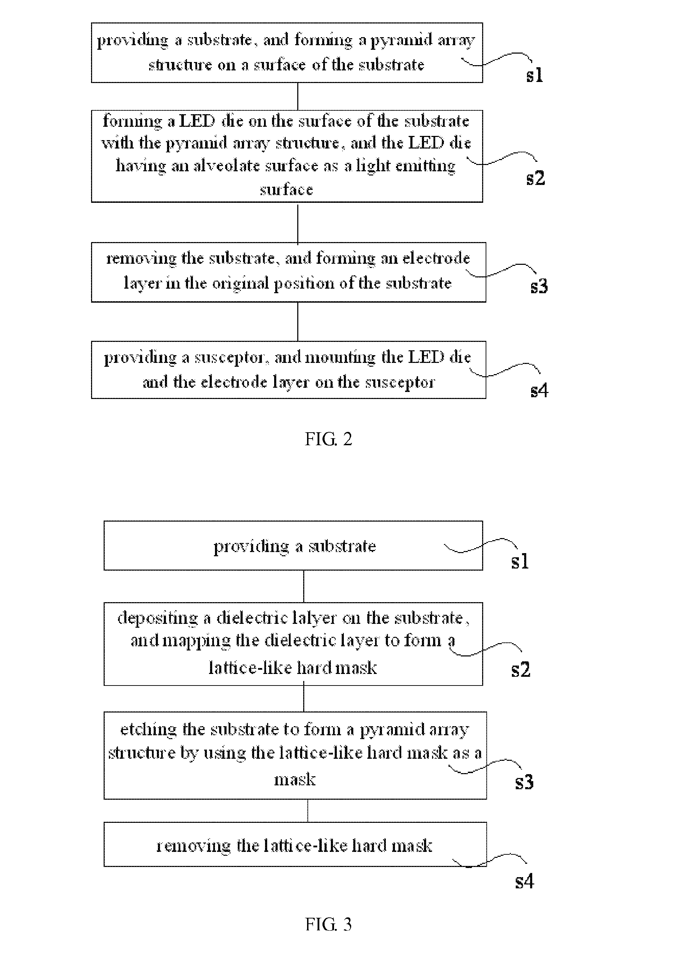

In order to manufacture the light emitting device described above, the present invention also provides a method for manufacturing the light emitting device. FIG. 2 is a flow chart of a method for manufacturing the light emitting device in the first embodiment. Referring to FIG. 2, the method for manufacturing the light emitting device comprises:
step s 1: providing a substrate, and forming a pyramid array structure on a surface of the substrate;
step s2: forming an LED die on a surface of the pyramid array structure, and the LED die having an alveolate surface which works as the light exiting surface of the LED die; wherein the LED die comprises an N-type semiconductor layer set on the electrode layer 210, an active layer set on the N-type semiconductor layer, a P-type semiconductor layer set on the active layer, and a transparent electrode set on the alveolate surface; wherein the alveolate surface is on the P-type semiconductor layer;
step s3: removing the substrate, and forming an electrode layer in the original position of the substrate; wherein a surface of the electrode layer which is opposite to the LED die is provided with a pyramid array structure which works as a reflective surface of the LED;
step s4: providing a susceptor, and mounting the LED die and the electrode layer on the susceptor.

FIG. 3 is a flow chart of the step s1 in the first embodiment according to the method shown in FIG. 2. Referring to FIG. 3, the step s1 comprises:
step s11: providing a substrate;
step s12: depositing a dielectric lalyer on the substrate, and patterning the dielectric layer to form a lattice-like hard mask;
step s13: etching the substrate to form a pyramid array structure by using the lattice-like hard mask as a mask;
step s14: removing the lattice-like hard mask.

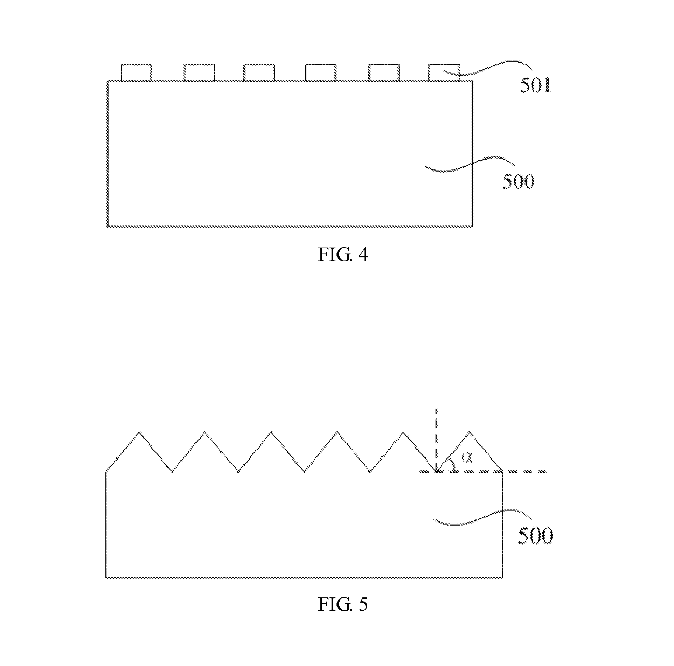

Specifically, referring to FIG. 4, a substrate 500 provided in the step s11 is a P-doped silicon substrate of (100) plane and has a resistivity ranging from 1 to 20 ohm-cm.

The dielectric lalyer in step s12 is made up of silicon dioxide. The lattice-like hard mask 501 is formed on the substrate 500 by performing a dry etching process on the dielectric lalyer.

Referring to FIG. 5, the steps s13 is performing a wet etching on the substrate 500 using tetramethyl ammonium hydroxide (TMAH) solution, wherein the etching time is 20 minutes and the etching temperature is 60∼80°C. A plurality of pyramids are formed after the wet etching, wherein the pyramids are provided with side walls in (111) planes and bottom surface in (100) planes. Specifically, every lattice of the hard mask is corresponding to a pyramid, and the pyramids are arranged in matrix. The pyramids are provided with square bottoms, and an angle fromed by a sidewall of the pyramids and a bottom wall of the pyramids is 54.74 °.

If the density of the pyramids is great, the pyramids formed by the wet etching process are not high enough; while, if the density of the pyramids is small, the number of the pyramids is not enough, and it is not conductive to increase the light emitting area of the LED. Ususlly, the density of the pyramids on the silicon substrate ranges from 4×10⁴ to 1×10⁸/mm²_{.} In the manufacturing process, the density of the pyramids can be controlled by adjusting the density of lattices of the hard mask. Preferably, the side length of the square bottoms of the pyramids is 5µm, and the height from the apex to the bottom surface of the pyramids is 3.53µm.

The step s14 is removing the lattice-like hard mask 501 by using hydrofluoric acid solution. Then the substrate with a pyramid array structure surface is formed.

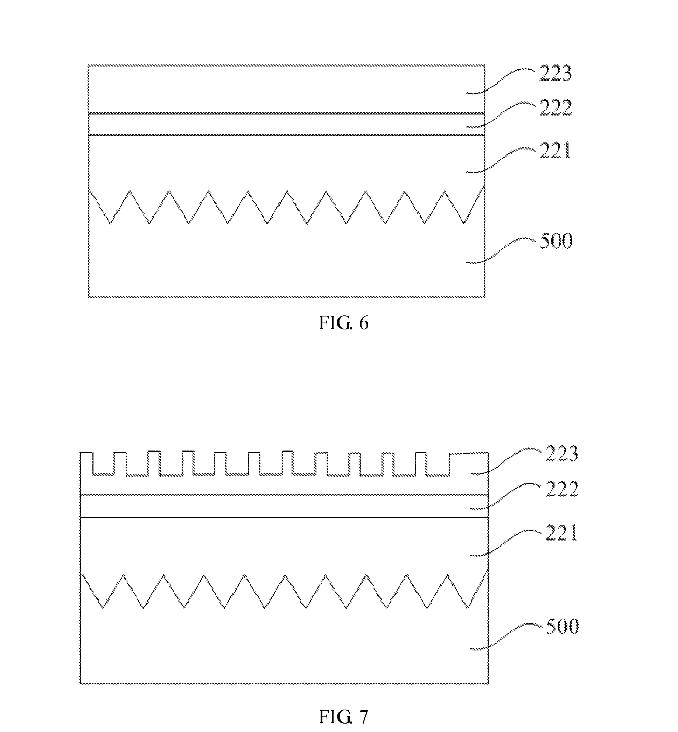

Referring to FIG. 6, the steps s2 is performed by using Metal-organic Chemical Vapor Deposition (MOCVD) to form an N-type semiconductor layer 221 on the (111) planes of the substrate 500, an active layer 222 on the N-type semiconductor layer 221, a P-type semiconductor layer 223 on the active layer 222. The N-type semiconductor layer 221, the active layer 222 and the P-type semiconductor layer 223 constitute the LED die.

According to this embodiment, while depositing the N-type semiconductor layer 221, the small openings between the pyramids on the surface of the substrate 500 is filled firstly until covering the whole pyramid array structure, thereby forming pyramid shaped depressions at the bottom of the N-type semiconductor layer 221, which are complementary to the pyramid array structure of the substrate.

According to this embodiment, the pyramids are provided with side walls in (111) planes, and the N-type semiconductor layer 221 is made up of N-doped GaN, because the lattice constant of GaN matches silicon of (111) crystal orientation. The N-type semiconductor layer 221 covers the pyramid array structure completely.

The active layer 222 is of the MQW active layer structure, specifically, is made up of InGaN, and is adapted for generating a blue light at a wavelength of 470 nm. The P-type semiconductor layer 223 is made up of P-type doped GaN.

Referring to FIG. 7, an alveolate surface is formed using a photolithography or dry etching process on the P-type semiconductor layer 223. Optionally, the diameter of the apertures on the alveolate surface is 200nm, the depth of of the apertures on the alveolate surface is 150nm, and the density of the apertures on the alveolate surface ranges from 1×10⁴ /mm² to 1×10¹⁰/mm².

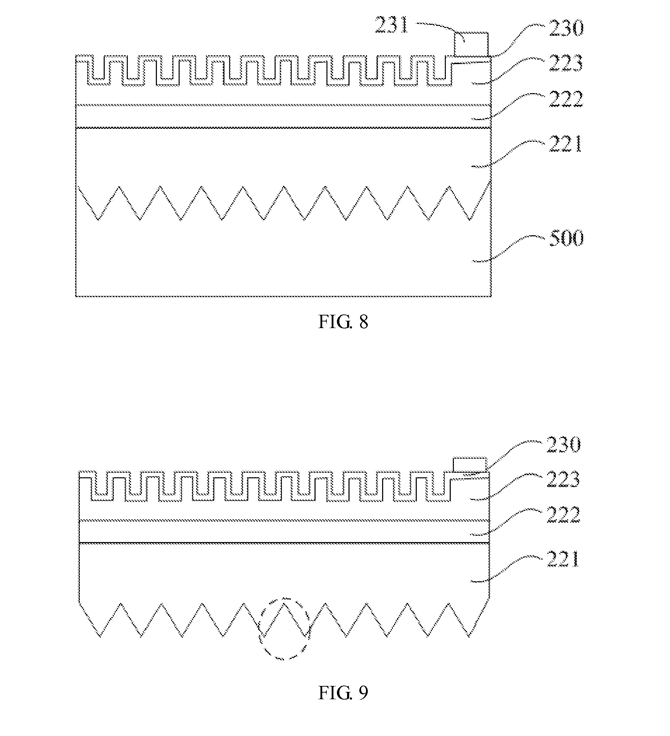

Referring to FIG. 8, a transparent electrode 230 is formed on the alveolate surface of the P-type semiconductor layer 223. The transparent electrode 230 should not be too thick, or it would affect the transmission of light. Specifically, the transparent electrode 230 is made up of Nickel or gold films, and has a thickness of 50nm. The transparent electrode 230 is formed by plasma enhanced chemical vapor deposition (PECVD), atomic layer deposition (ALD) or ion beam deposition process using an e-GUN evaporator.

In order to form a gold lead in the following process which is connected to the transparent electrode 230, a connecting electrode 231 is formed at the lead positon of the transparent electrode 230. The connecting electrode 231 is made up of P-doped GaN and is formed by Chemical vapor deposition process.

Referring to FIG. 9, the step s3 is perfomed as follows. The substrate 500 is removed through a wet etching process by potassium hydroxide solution. After the substrate 500 is removed, the N-type semiconductor layer 221 at the bottom of the LED die 220 is exposed and the bottom of the N-type semiconductor layer 221 is shown of pyramid shaped depressions, which are complementary to the pyramid array structure of the substrate (as shown in the dotted ellipse in FIG. 9).

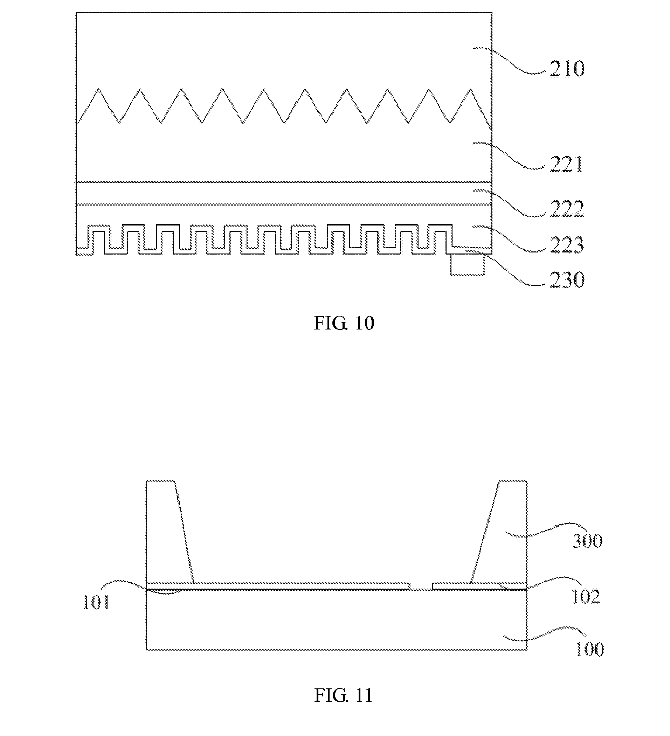

Referring to FIG. 10, an electrode layer 210 is formed at the original position of the substrate 500. Specifically, the electrode layer 210 is formed as follows: inverting the LED die 220, and then depositing electrode material on the surface of the N-type semiconductor layer 221 which is shown of pyramid shaped depressions. The electrode layer 210 completely covers the the surface shown in pyramid shaped depressions of the N-type semiconductor layer 221, thereby forming a pyramid array structure which is similar to the substrate 500. The electrode layer 210 is made up of titanium, aluminum, gold or other metals with higher reflectivity. The electrode layer 210 is formed by a PECVD or a sputting process. The pyramid arrary structure surface of the electrode layer 210 works as the reflective surface of the LED.

Hereto, the LED of the present invention comprising the electrode layer 210, the LED die 220 and the transparent electrode 230 is finished. Hereinafter, the LED is fixed in a susceptor and packed.

Referring to FIG. 11, the step s4 is perfomed as follows: providing a susceptor 100, and forming a first pin 101 and a second pin 102 on the susceptor 100, wherein the first pin 101 is adapted for connecting a positive electrode of a power supply and the second pin 102 is adapted for connecting a negative electrode of the power supply. Furthermore, an annular reflective layer 300 is formed on the susceptor 100 and surrounding the LED 200. The annular reflective layer 300 is provided with a gradient inner surface which is coated with reflective material, such as barium oxide film. The gradient inner surface of the annular reflective layer 300 is adapted for reflecting the light escaping from the side of the LED 200 to the desired emitting direction.

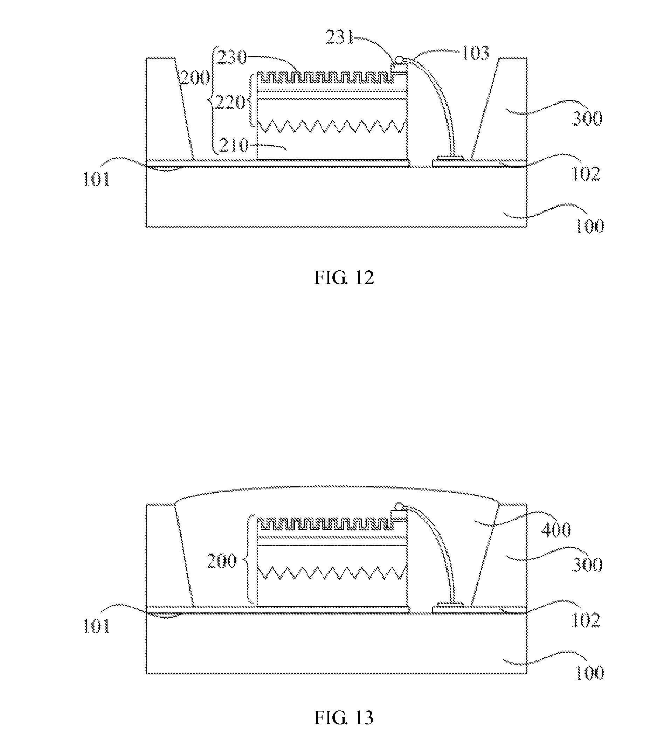

Referring to FIG. 12, the LED formed in FIG. 10 is mounted on the susceptor 100. Firstly, the electrode layer 210 is fixed on the first pin 101, thus connecting the electrode layer 210 to the first pin 101. Secondly, the connecting electrode 231 which is located on the transparent electrode 230 is connected to the second pin 102 through a gold lead 103.

Referring to FIG. 13, the groove surrounded by the annular reflective layer 300 is filled with a package resin 400, until the package resin 400 covers the LED 200. The surface of the packaging resin 400 is shaped embowed, thus forming a lens structure, thereby assembling the light emitted from or reflected by the LED 200 to the desired emitting direction.

Hereto, the manufacturing of the light emitting device is finished.

In conclusion, the present invention provides a light emitting device comprising: an alveolate light exiting surface and an LED having a pyramid array reflective surface, which increases the light emitting and reflective area of the LED, thereby improving the luminous efficiency.

The light emitting device further comprises a reflective layer which is adapted for reflecting the light escaping from the side of the LED to the desired emitting direction, thereby further improving the luminous efficiency.

The light emitting device further comprises a package resin adapted for protecting the LED and having a lens structure, which is adapted for increasing the brightness of the light emitting device.

The method for manufacturing the light emitting device provided in the present invention adopts a surface mount technology, which is easy to implemento

Although the present invention has been disclosed as above with reference to preferred embodiments thereof but will not be limited thereto. Those skilled in the art can modify and vary the embodiments without departing from the spirit and scope of the present invention. Accordingly, the scope of the present invention shall be defined in the appended claims.

## Claims

1. A light emitting device **characterized by** comprising:
a susceptor; and
a light emitting diode mounted on the susceptor;
wherein the light emitting diode comprises:
an electrode layer connected to the susceptor, the electrode layer having a pyramid array structure surface which works as a reflective surface of the light emitting diode; and
an LED die set on the electrode layer, the LED die having an alveolate surface which works as the light exiting surface of the LED.

2. The light emitting device as claimed in claim 1, **characterized in that** the LED die comprises an N-type semiconductor layer set on the electrode layer, an active layer set on the N-type semiconductor layer, and a P-type semiconductor layer set on the active layer, wherein the alveolate surface is set on the P-type semiconductor layer.

3. The light emitting device as claimed in claim 2, **characterized in that** the diameter of the apertures on the alveolate surface is 200nm and the depth of of the apertures on the alveolate surface is 150nm.

4. The light emitting device as claimed in claim 2, **characterized in that** the density of the apertures on the alveolate surface ranges from 1×10⁴ /mm² to 1×10¹⁰ /mm².

5. The light emitting device as claimed in claim 2, **characterized in that** the alveolate surface on the P-type semiconductor layer has a transparent electrode.

6. The light emitting device as claimed in claim 5, **characterized in that** the transparent electrode is made up of Nickel or gold films and has a thickness of 50nm.

7. The light emitting device as claimed in claim 2, **characterized in that** the N-type semiconductor layer is made up of N-doped GaN, and the P-type semiconductor layer is made up of P-doped GaN.

8. The light emitting device as claimed in claim 2, **characterized in that** the active layer is of the MQW active layer structure and made up of InGaN.

9. The light emitting device as claimed in claim 1, **characterized in that** the electrode layer is made up of titanium, aluminum or gold.

10. The light emitting device as claimed in claim 5, **characterized in that** the lighting emitting device further comprises a first pin and a second pin, wherein the first pin is connected to the electrode layer and a negative electrode of a power supply and the second pin is connected to the transparent electrode and a positive electrode of the power supply.

11. The light emitting device as claimed in claim 10, **characterized in that** the second pin is connected to the transparent electrode through a gold lead.

12. The light emitting device as claimed in claim 1, **characterized in that** an annular reflective layer is formed on the susceptor, said annular reflective layer being surrounding the lighting emitting diode and forming a groove accommodating the lighting emitting diode.

13. The light emitting device as claimed in claim 12, **characterized in that** the groove is filled with a package resin which covers the lighting emitting diode.

14. The light emitting device as claimed in claim 13, **characterized in that** the surface of the package resin has a lens structure.

15. A method for manufacturing a light emitting device **characterized by** comprising:
providing a substrate and forming a pyramid array structure on a surface of the substrate;
forming an LED die on the surface of the substrate with the pyramid array structure, and a surface of the LED die which is opposite to the substrate having an alveolate surface;
removing the substrate, and forming an electrode layer in the original position of the substrate; and
providing a susceptor, and mounting the LED die and the electrode layer on the susceptor.

16. The method for manufacturing a light emitting device as claimed in claim 15, **characterized in that** the step of providing a substrate and forming a pyramid array structure on a surface of the substrate comprises:
providing a substrate, depositing a dielectric lalyer on the substrate, and patterning the dielectric layer to form a lattice-like hard mask;
etching the substrate to form a pyramid array structure by using the lattice-like hard mask as a mask; and
removing the lattice-like hard mask.

17. The method for manufacturing a light emitting device as claimed in claim 16, **characterized in that** said substrate is a P-doped silicon substrate of (100) plane and said etching the substrate to form a pyramid array structure by using the lattice-like hard mask as a mask comprises performing a wet etching on the substrate using tetramethyl ammonium hydroxide (TMAH) solution and forming a pyramid array structure, wherein the pyramids are provided with side walls in (111) planes and bottom surface in (100) planes, wherein said (111) planes are the formation surface of the LED die.

18. The method for manufacturing a light emitting device as claimed in claim 17, **characterized in that** said wet etching on the substrate using tetramethyl ammonium hydroxide (TMAH) solution is performed for 20 minutes and the etching temperature ranges from 60°C to 80°C.

19. The method for manufacturing a light emitting device as claimed in claim 17, **characterized in that** an angle fromed by a sidewall of the pyramids and a bottom wall of the pyramids is 54.74 °.

20. The method for manufacturing a light emitting device as claimed in claim 17, **characterized in that** a density of the pyramids of the pyramids array structure ranges from 4 × 10⁴/mm² to 1×10⁸/mm²_{.}

21. The method for manufacturing a light emitting device as claimed in claim 17, **characterized in that** said forming an LED die on the (111) planes of the substrate comprises:
forming an N-type semiconductor layer on the (111) planes of the substrate, forming an active layer on the N-type semiconductor layer, and forming a P-type semiconductor layer on the active layer;
forming an alveolate surface using a photolithography or dry etching process on the P-type semiconductor layer; and
forming a transparent electrode on the alveolate surface.

22. The method for manufacturing a light emitting device as claimed in claim 21, **characterized in that** diameter of the apertures on the alveolate surface is 200nm and depth of of the apertures on the alveolate surface is 150nm.

23. The method for manufacturing a light emitting device as claimed in claim 21, **characterized in that** density of the apertures on the alveolate surface ranges from 1×10⁴ /mm² to 1×10¹⁰ /mm².

24. The method for manufacturing a light emitting device as claimed in claim 21, **characterized in that** the transparent electrode is made up of Nickel or gold films and has a thickness of 50nm.

25. The method for manufacturing a light emitting device as claimed in claim 24, **characterized in that** the Nickel or gold films is formed by plasma enhanced chemical vapor deposition (PECVD), atomic layer deposition (ALD) or ion beam deposition process using an e-GUN evaporator.

26. The method for manufacturing a light emitting device as claimed in claim 17, **characterized in that** the substrate is removed by using potassium hydroxide solution.

27. The method for manufacturing a light emitting device as claimed in claim 15, **characterized in that** the electrode layer is made of titanium, aluminum or gold.

28. The method for manufacturing a light emitting device as claimed in claim 17, **characterized in that** the removing the substrate and forming the electrode layer on the original position of the substrate is using a PECVD or a sputting process.

29. The method for manufacturing a light emitting device as claimed in claim 21, **characterized in that** said mounting the LED die and the electrode layer on the susceptor comprises:
forming a first pin and a second pin on the susceptor, the first pin being for connecting a positive electrode of a power supply and the second pin being for connecting a negative electrode of the power supply;
fixing the electrode layer on the first pin; and
connecting the transparent electrode to the second pin through a gold lead.

30. The method for manufacturing a light emitting device as claimed in claim 29, **characterized in that** before mounting the LED die and the electrode layer on the susceptor, an annular reflective layer is formed on the susceptor, said annular reflective layerbeing surrounding the LED die.

31. The method for manufacturing a light emitting device as claimed in claim 30, **characterized in that** a groove surrounded by the annular reflective layer is filled with a package resin and the package resin covers the LED die and the electrode layer.

32. The method for manufacturing a light emitting device as claimed in claim 31, **characterized in that** a surface of the packaging resin has a lens structure.
